# EUROPEAN PATENT APPLICATION

(11) **EP 4 586 746 A1**
(43) Date of publication of application: **16.07.2025**
(21) Application number: 23862686.5
(22) Date of filing: 07.03.2023
(51) Int. Cl.: H05H 1/46, H01L 21/3065

(54) **PLASMA GENERATION DEVICE AND PLASMA TREATMENT DEVICE**

(30) Priority: 05.09.2022 JP 2022140765
(71) Applicant: Nissin Inc., Takarazuka-shi, Hyogo-ken 665-0047 (JP)
(72) Inventor: NANKO, Shohei, Takarazuka-shi, Hyogo 665-0047 (JP)
(74) Representative: Hauck Patent- und Rechtsanwälte PartmbB
(86) International application number: PCT/JP2023/008564
(87) International publication number: WO 2024/053136

(57) **Abstract**

Provided are an outer conductor 29 as a conductive waveguide having an opening 34 at a first end, a first dielectric 31 extending along a main axis of the outer conductor 29 in an interior of the outer conductor 29, connected to a microwave supply cable 5 that supplies microwaves, and configured to propagate the supplied microwaves to the first end side, and a second dielectric 33 arranged so as to close the opening 34 and configured to generate plasma with use of the microwaves propagated by the first dielectric 31.

## Description

### Technical Field

The present invention relates to a plasma generating apparatus configured to generate plasma, and a plasma processing apparatus, provided with the plasma generating apparatus, for performing plasma processing to a workpiece.

### Background Art

Plasma is used in a production process of semiconductor products, liquid crystal panels, and the like in surface cleaning, etching, CVD process, and the like. In addition, plasma is also used for surface modification or water-repellent treatment of an object to be processed (hereinafter, collectively referred to as "workpiece") in a wide range of other fields.

An apparatus for performing plasma processing to a workpiece includes a microwave generating unit configured to generate microwaves, a plasma generating apparatus configured to generate plasma with use of microwave energy, and a plasma processing unit connected to the plasma generating apparatus and accommodating the workpiece. The plasma processing unit is a metal vacuum chamber as one example, and one or two or more plasma generating apparatus are connected to the plasma processing unit.

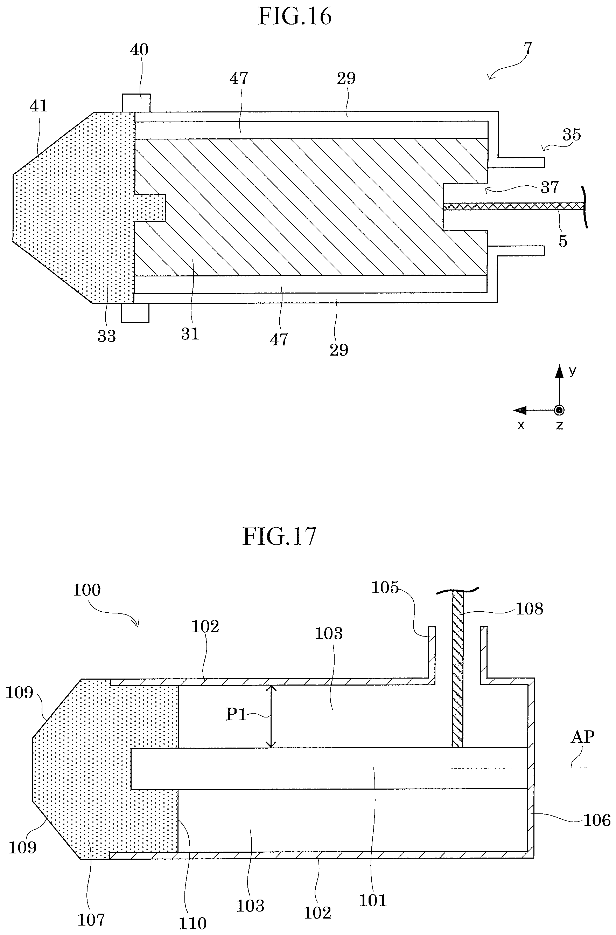

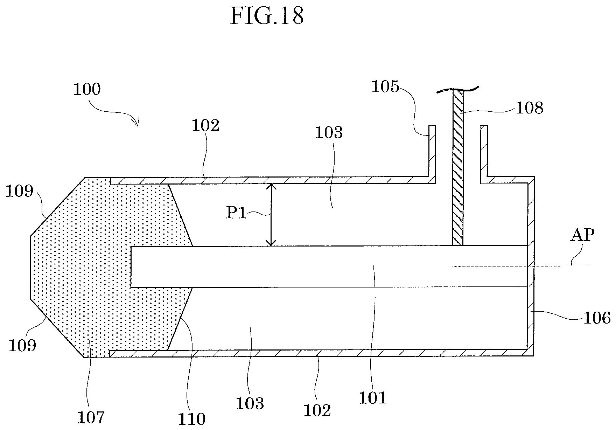

As a plasma generating apparatus used in a plasma processing device, an apparatus provided with a coaxial tube structure and generating plasma at its front end (coaxial applicator) is known (for example, Patent Literature 1). The conventional plasma generating apparatus 100 according to the Patent Literature 1 includes a central core 101, an outer shield 102, a coupling system 105, and a dielectric body 107, as shown in Fig. 17 or Fig. 18. The central core 101 is formed by a conductive rod-shaped member, and extends along a main axis AP of the plasma generating apparatus 100. The central core 101 corresponds to a so-called inner conductor in the plasma apparatus 100.

The outer shield 102 is a conductive cylindrical member, and is located so as to surround the central core 101. The outer shield 102 corresponds to a so-called outer conductor in the plasma generating apparatus 100. The outer shield 102 has an opening formed on a distal end side (left side in Fig. 17) thereof, and is closed with a partition 106 on a proximal end side (right side in Fig. 17) thereof. A propagation medium 103 for propagating microwave energy is provided between the central core 101 and the outer shield 102. Examples of the propagation medium 103 include air.

The coupling system 105 connects a microwave generating unit, not shown, to the plasma apparatus 100. The coupling system 105 is located on a side wall of the outer shield 102 close to the partition 106, as shown in Fig. 17, as an example. A microwave transmission cable 108 extending from the microwave generating unit, not shown, is guided through the opened coupling system 105 into an interior of the plasma generating apparatus 100.

The dielectric body 107 is composed of an insulator that propagates microwaves, and is arranged to close the opening on a distal end side of the outer shield 102. The dielectric body 107 is connected to the central core 101. The dielectric body 107 connects the propagation medium 103 of the plasma generating apparatus 100 to an interior space of a plasma generating unit. An outer surface 109 of the dielectric body 107 is tapered from the proximal end side toward the distal end side of the outer shield 102.

In the conventional plasma generating apparatus 100, plasma is generated by microwaves outputted from the microwave generating unit. That is, microwave energy inputted via the microwave transmission cable 108 is propagated into the interior of the plasma generating apparatus 100 via the coupling system 105. Moreover, the microwave energy is propagated in the interior of the plasma generating apparatus 100 to the dielectric body 107, and gas in contact with the outer surface 109 of the dielectric body 107 is excited, whereby plasma is generated.

### Citation List

### Patent Literature

[Patent Literature 1]
Japanese Patent Publication (Translation of PCT Application) No. 2018-530128

### Summary of Invention

### Technical Problem

However, the example of the conventional apparatus with such a construction has the following drawbacks.

A first problem in the conventional example is that dielectric breakdown easily occurs in the conventional plasma generating apparatus 100 when microwaves having large output are injected. Accordingly, it is difficult to generate plasma having high output in the conventional plasma generating apparatus 100.

The following is a conceivable cause of dielectric breakdown problems in the conventional apparatus. That is, in the conventional plasma generating apparatus 100, the conductive central core 101 is located in a middle part of the cylindrical outer shield 102, so that an insulation distance is a distance P1 from an inner face of the outer shield 102 to a surface of the central core 101. In other words, the insulation distance is limited to a distance smaller than a radius of the outer shield 102, which makes it easier for dielectric breakdown to occur in the plasma generating apparatus 100. In order to ensure the sufficient insulation distance for avoiding occurrence of dielectric breakdown, the radius of the outer shield 102 is necessarily increased. Therefore, it is very difficult to reduce in size of the plasma generating apparatus 100 while avoiding dielectric breakdown.

A second problem in the conventional example is that heat tends to accumulate inside the conventional plasma generating apparatus 100 and it is difficult to release the heat to the outside. That is, output of microwaves has to be kept low to suppress heat accumulation in the plasma generating apparatus 100. Therefore, it is more difficult to generate plasma having high output.

The following is a conceivable cause of a problem that the heat tends to accumulate in the conventional apparatus. That is, in the plasma generating apparatus 100, a region where the central core 101 is in contact with the outer shield 102 is limited to a very narrow region. The central core 101 is in direct contact with the outer shield 102 only at a proximal end of the plasma generating apparatus 100. Accordingly, it is difficult to efficiently release the heat (Joule heat) generated on the surface of the central core 101 to the outside of the plasma generating apparatus 100.

A third problem in the conventional example is a high manufacturing cost of the plasma generating apparatus 100. That is, in the plasma generating apparatus 100, if the dielectric body 107 is made in a simple cylindrical shape, impedance matching decreases. In order to improve the impedance matching in the plasma generating apparatus 100, the outer surface 109 of the dielectric body 107 is necessarily tapered. In other words, processing the outer surface 109 of the dielectric body 107 increases the manufacturing cost of the plasma generating apparatus 100.

In addition, in order to enhance impedance in the plasma generating apparatus 100, not only the outer surface 109 of the dielectric body 107 but also an inner surface 110 of the dielectric body 107 that contacts the propagation medium 103 is necessarily tapered as shown in Fig. 18. When the inner surface 110 is tapered in addition to the outer surface 109, the manufacturing cost of the plasma generating apparatus 100 further increases.

The present invention has been made regarding the state of the art noted above, and its object is to provide a plasma generating apparatus and a plasma processing apparatus that enable enhanced output of plasma and reduction in size of the apparatus.

### Solution to Problem

The present invention is constituted as stated below to achieve the above object.

One aspect of the present invention provides plasma generating apparatus, including a conductive waveguide having an opening at a first end,
a first dielectric member extending along a main axis of the waveguide in an interior of the waveguide, connected to a microwave supply cable that supplies microwaves, and configured to propagate the supplied microwaves to the first end side, and
a second dielectric member arranged so as to close the opening and configured to generate plasma with use of the microwaves propagated by the first dielectric member.

(Effect) According to this construction, the conductive waveguide having the opening at the first end side is used, and the first dielectric member extends along the main axis of the waveguide in the interior of the waveguide. Moreover, the opening of the waveguide is closed by the second dielectric member, the microwaves propagated by the first dielectric member to the first end side are received by the second dielectric member, and the second dielectric member generates plasma with use of the microwaves.

In other words, the plasma generating apparatus according to the present invention has a waveguide structure in its entirety, and includes no inner conductor. The absence of the inner conductor can avoid such a situation where an insulation distance of the plasma generating apparatus is shortened due to the presence of the inner conductor. Accordingly, occurrence of dielectric breakdown is avoidable even when microwaves having high output are supplied. Therefore, output of plasma in the plasma generating apparatus can be enhanced while the occurrence of dielectric breakdown is prevented more reliably.

In addition, since such a situation can be avoided where an insulation distance of the plasma generating apparatus is shortened due to the presence of the inner conductor, even when a diameter of the waveguide is shortened, occurrence of dielectric breakdown can be avoided more reliably. That is, the plasma generating apparatus can be downsized while occurrence of dielectric breakdown is avoided more reliably.

Moreover, it is preferred in the aspect of the present invention described above that the first dielectric member extends along the main axis of the waveguide so as to fill the interior of the waveguide.

(Effect) According to this construction, the first dielectric member fills the interior of the waveguide. That is, a surface of the first dielectric member entirely contacts the waveguide. By filling the interior of the waveguide with the first dielectric member, the first dielectric member that propagates microwaves is brought into contact with the waveguide as an outer conductor over a wide area. Accordingly, heat generated in the first dielectric member can be conducted to the waveguide efficiently, and can be released outside the plasma generating apparatus. As a result, accumulation of heat in the first dielectric member can be avoided even when microwaves having high output are supplied, achieving prevention of high temperatures of the plasma generating apparatus and increase in output of plasma in the plasma generating apparatus.

Moreover, it is preferred in the aspect of the present invention described above that the first dielectric member includes a relative dielectric constant buffer configured to moderate a change in relative dielectric constant at a connecting portion with the microwave supply cable.

(Effect) According to this construction, the first dielectric member includes the relative dielectric constant buffer. The relative dielectric constant buffer moderates the change in relative dielectric constant at the connecting portion between the microwave supply cable and the first dielectric member. The microwave supply cable and the first dielectric member are connected via the relative dielectric constant buffer, whereby the change in relative dielectric constant is reduced at an area from the microwave supply cable to the first dielectric member. Accordingly, provision of the relative dielectric constant buffer can avoid degradation of the impedance matching caused by a sudden change in relative dielectric constant.

Moreover, it is preferred in the aspect of the present invention described above that the relative dielectric constant buffer is a recess formed in the first dielectric member and that the microwave supply cable is inserted in a direction in which the recess extends.

(Effect) According to this construction, the recess is formed in the first dielectric member, and the microwave supply cable is inserted into the recess. In this case, in a region of the recess where the microwave supply cable is inserted, a region filled by the first dielectric member and a region filled by gas around the microwave supply cable are mixed. That is, a relative dielectric constant in the recess where the microwave supply cable is inserted is lower than a relative dielectric constant of the first dielectric member, and is higher than a relative dielectric constant of the gas around the microwave supply cable. This results in a change in relative dielectric constant is reduced at the area from the microwave supply cable to the first dielectric member. Accordingly, a simple design to form the recess can avoid degradation of the impedance matching caused by a sudden change in relative dielectric constant.

Moreover, it is preferred in the aspect of the present invention described above that the relative dielectric constant buffer is a connecting member formed with a material whose relative dielectric constant is lower than that of the first dielectric member and that the first dielectric member is connected to the microwave supply cable via the connecting member.

(Effect) According to this construction, the connecting member formed with the material whose relative dielectric constant is lower than that of the first dielectric member is provided, and the first dielectric member is connected to the microwave supply cable via the connecting member. Since the connecting member is formed with the material whose relative dielectric constant is lower than that of the first dielectric member, a change in relative dielectric constant of the area from the microwave supply cable to the first dielectric member is reduced. Accordingly, the simple construction of arranging the connecting member between the microwave supply cable and the first dielectric member can avoid degradation of the impedance matching caused by a sudden change in relative dielectric constant.

Moreover, it is preferred in the aspect of the present invention described above that the first dielectric member includes a second relative dielectric constant buffer configured to moderate a change in relative dielectric constant at a connecting portion with the second dielectric member.

(Effect) According to this construction, the first dielectric member includes the second relative dielectric constant buffer. The second relative dielectric constant buffer moderates the change in relative dielectric constant at a connecting portion between the first dielectric member and the second dielectric member. The first dielectric member and the second dielectric member are connected via the second relative dielectric constant buffer, whereby a change in relative dielectric constant is reduced at an area from the first dielectric member to the second dielectric member. Accordingly, provision of the second relative dielectric constant buffer can ensure to avoid degradation of the impedance matching caused by a sudden change in relative dielectric constant.

The present invention may be constituted as stated below to achieve the above object.

Another aspect of the present invention provides a plasma processing apparatus, including a microwave supply unit configured to supply microwaves,
a plasma generating unit configured to generate plasma with use of the microwaves supplied from the microwave supply unit, and
a plasma processing unit configured to process a workpiece with use of the plasma generated by the plasma generating unit,
and the plasma generating unit is the plasma generating apparatus according to any of claims 1 to 5.

(Effect) According to this construction, plasma is generated by supplying microwaves to the plasma generating apparatus according to the present invention, and plasma processing is performed to the workpiece with use of the plasma. This can produce an effect of the present invention in the apparatus for performing the plasma processing to the workpiece. In other words, the plasma generating apparatus according to the present invention can avoid occurrence of dielectric breakdown and the like more reliably even when microwaves having high output are supplied, thereby realizing plasma processing of a workpiece with plasma having high output while preventing occurrence of dielectric breakdown and the like.

### Advantageous Effects of Invention

With the plasma generating apparatus and the plasma processing apparatus according to the present invention, the conductive waveguide having the opening on the first end side is used, and the first dielectric member extends along the main axis of the waveguide in an interior of the waveguide. Moreover, the opening of the waveguide is closed by the second dielectric member, the microwaves propagated by the first dielectric member to the first end side are received by the second dielectric member, and the second dielectric member generates plasma with use of the microwaves.

Specifically, plasma is generated by supplying microwaves to the waveguide that does not include an inner conductor but includes a dielectric member. The absence of the inner conductor can avoid such a situation where an insulation distance is shortened due to the presence of the inner conductor. Accordingly, occurrence of dielectric breakdown is avoidable even when microwaves having high output are supplied. Therefore, output of plasma in the plasma generating apparatus can be enhanced while the occurrence of dielectric breakdown is prevented more reliably.

In addition, such a situation can be avoided where an insulation distance is shortened due to the presence of the inner conductor. Accordingly, even when a diameter of the waveguide is shortened, occurrence of dielectric breakdown can be avoided more reliably. That is, the plasma generating apparatus can be downsized while occurrence of dielectric breakdown is avoided more reliably. Therefore, the plasma generating apparatus and the plasma processing apparatus can be realized that enable enhanced output of plasma and reduction in size of the apparatus.

### Brief Description of Drawings

Fig. 1 is a schematic view illustrating an overall construction of a plasma processing apparatus according to a first embodiment.
Fig. 2 is a longitudinal sectional view illustrating a construction of a plasma generating unit according to the first embodiment.
Fig. 3 is a perspective view illustrating a construction of the plasma generating unit according to the first embodiment.
Fig. 4 illustrates a condition where the plasma generating unit and a plasma processing unit are combined in the plasma processing apparatus according to the first embodiment.
Fig. 5 illustrates a condition where a first dielectric, a second dielectric, and an outer conductor are combined in the plasma generating unit according to the first embodiment.
Fig. 6 illustrates a change in relative dielectric constant in a plasma generating unit according to one comparative example; Fig. 6(a) is a longitudinal sectional view of a proximal end side of the plasma generating unit, and Fig. 6(b) is a graph of a change in relative dielectric constant in an input direction of microwaves on the proximal end side of the plasma generating unit.
Fig. 7 illustrates a change in relative dielectric constant in the plasma generating unit according to the first embodiment; Fig. 7(a) is a longitudinal sectional view of a proximal end side of the plasma generating unit, and Fig. 7(b) is a graph of a change in relative dielectric constant in an input direction of microwaves on the proximal end side of the plasma generating unit.
Fig. 8 illustrates an effect from a construction of the first embodiment; Fig. 8(a) is a longitudinal sectional view illustrating a heat exhaust efficiency in a conventional example, and Fig. 8(b) is a longitudinal sectional view illustrating a heat exhaust efficiency in the first embodiment.
Fig. 9 is a longitudinal sectional view illustrating a construction of a plasma generating unit according to one modification; Fig. 9(a) being a modification in which a distal end of the second dielectric is in a cylindrical shape, and Fig. 9(b) being a modification in which the distal end of the second dielectric becomes thicker toward the distal end thereof.
Fig. 10 is a longitudinal sectional view illustrating a construction of a plasma generating unit according to the second embodiment.
Fig. 11 illustrates a change in relative dielectric constant in the plasma generating unit according to the second embodiment; Fig. 11(a) is a longitudinal sectional view of a proximal end side of the plasma generating unit, and Fig. 11(b) is a graph of a change in relative dielectric constant in an input direction of microwaves on the proximal end side of the plasma generating unit.
Fig. 12 is a longitudinal sectional view illustrating a construction of a plasma generating unit according to a third embodiment.
Fig. 13 illustrates a change in relative dielectric constant in the plasma generating unit according to the third embodiment; Fig. 13(a) is a longitudinal sectional view of a proximal end side of the plasma generating unit, and Fig. 13(b) is a graph of a change in relative dielectric constant in an input direction of microwaves on the proximal end side of the plasma generating unit.
Fig. 14 is a longitudinal sectional view illustrating a construction of a plasma generating unit according to another modification.
Fig. 15 is a longitudinal sectional view illustrating a construction of a plasma generating unit according to another modification.
Fig. 16 is a longitudinal sectional view illustrating a construction of a plasma generating unit according to another modification.
Fig. 17 is a longitudinal sectional view illustrating a construction of a plasma generating apparatus according to the conventional example.
Fig. 18 is a longitudinal sectional view illustrating a construction of the plasma generating apparatus according to the conventional example.
Fig. 19 illustrates a change in relative dielectric constant in a plasma generating unit according to another modification; Fig. 19(a) being a longitudinal sectional view of the plasma generating unit, and Fig. 19(b) being a graph of a change in relative dielectric constant in an input direction of microwaves of the plasma generating unit.

### Description of Embodiments

### First embodiment

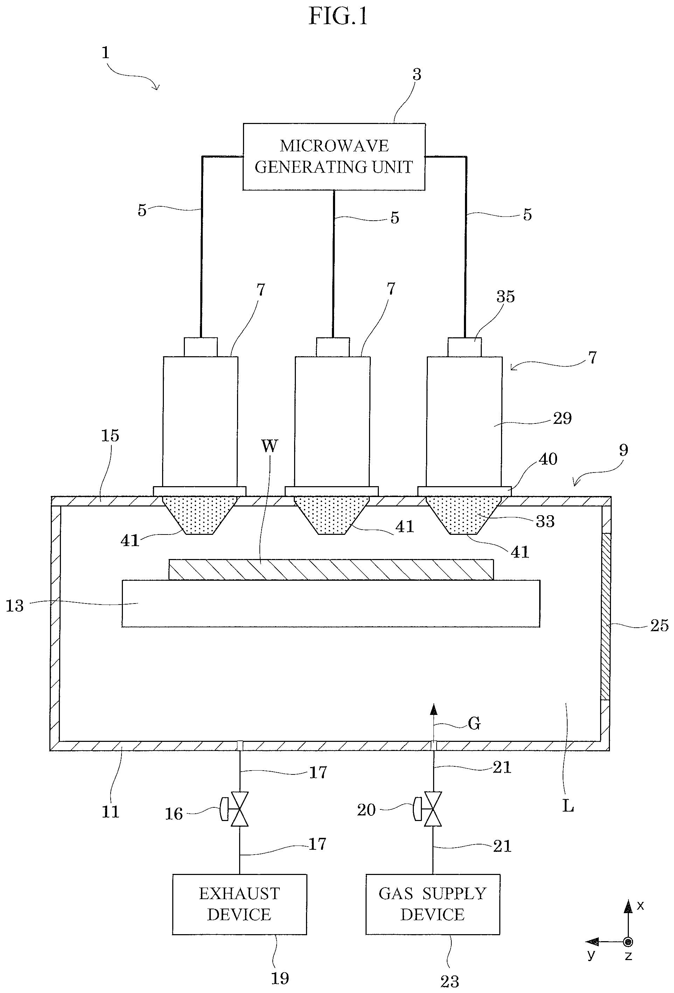

The following describes a first embodiment of the present invention with reference to drawings. Fig. 1 is a schematic view illustrating of a plasma processing apparatus 1 according to the first embodiment.

### <Description of overall construction>

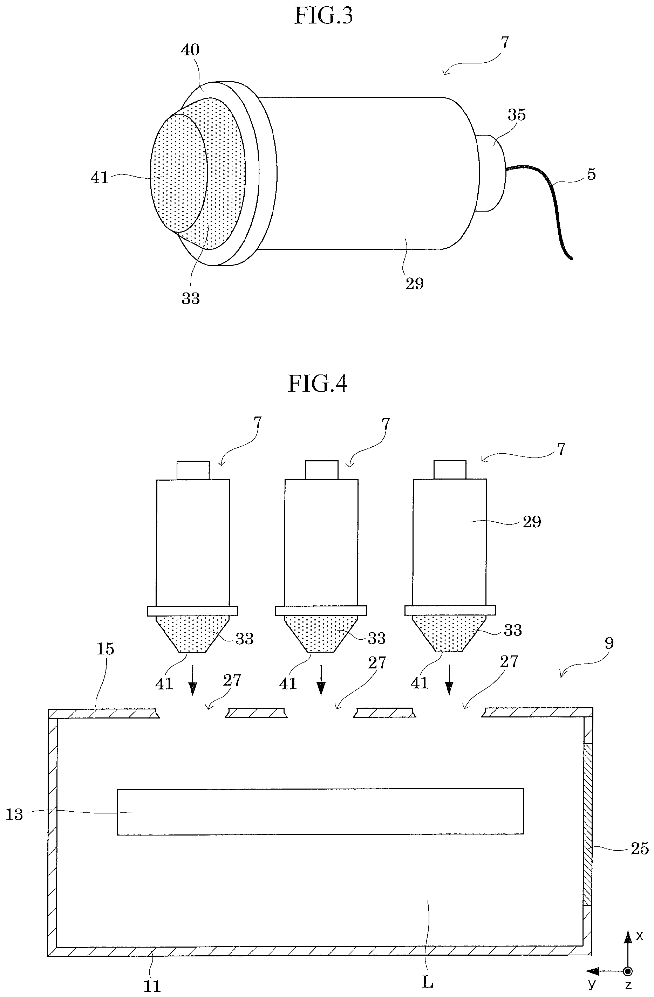

The plasma processing apparatus 1 according to the first embodiment includes a microwave generating unit 3, microwave supply cables 5, plasma generating units 7, and a plasma processing unit 9. Note that the plasma processing unit 9 is shown in a longitudinal sectional view in Figs. 1 and 4.

The microwave generating unit 3 oscillates microwaves of a specific frequency while the frequency is variable. In this embodiment, it is assumed that the microwave generating unit 3 oscillates microwaves of 2.45 GHz. The microwave supply cables 5 are connected to the microwave generating unit 3 and each of the plasma generating units 7 , and propagate microwaves oscillated from the microwave generating unit 3 and supply the microwaves to each of the plasma generating units 7.

Each of the plasma generating unit 7 generates plasma at its distal end with use of energy of the microwaves supplied from the microwave generating unit 3. The plasma generating units 7 are connected to the plasma processing unit 9, and the distal ends where plasma is generated are each configured to contact an interior space L of the plasma processing unit 9.

In this embodiment, the plasma processing apparatus 1 is exemplarily shown with three plasma generating units 7, but the number of plasma generating units 7 may be changed appropriately. The plasma processing apparatus 1 includes microwave supply cables 5 whose number corresponds to the number of plasma generating units 7. The microwave supply cables 5 are connected to the plasma generating units 7 individually. A construction of the plasma generating unit 7 is to be described later. The plasma generating unit 7 corresponds to the plasma generating apparatus in the present invention.

The plasma processing unit 9 performs plasma processing to a workpiece W. Specifically, the plasma processing unit 9 performs predetermined processing to the workpiece W with use of plasma generated by the plasma generating unit 7. Examples of the workpiece W include a semiconductor product, a liquid crystal panel, and a solar cell array.

The plasma processing unit 9 includes a chamber 11 and a workpiece holder 13. The chamber 11 includes a connecting plate 15, and is in fluid communication with an exhaust device 19 via an exhaust channel 17 provided with an electromagnetic valve 16, as shown in Fig. 1. The exhaust device 19 activates, whereby the interior space L of the chamber 11 is degassed and decompressed.

The chamber 11 is in fluid communication with a gas supply device 23 via a supply channel 21 provided with an electromagnetic valve 20. The gas supply device 23 supplies predetermined gas G to the interior space L of the chamber 11. Examples of the gas G supplied by the gas supply device 23 include rare gas, such as argon gas, or oxygen.

The chamber 11 also includes an open/close door 25. The open/close door 25 is formed on a side face of the chamber 11 as an example, and is configured to be openable and closeable. When the open/close door 25 is in an opened state, a workpiece transport mechanism not shown can load and unload the workpiece W to and from the chamber 11. Opening and closing of the electromagnetic valve 16 and the electromagnetic valve 20, operation of the exhaust device 19 and the gas supply device 23, and opening and closing of the open/close door 25 are collectively controlled by a control mechanism, not shown, provided with a computer and the like. The control mechanism also performs collective control of other various operations in the plasma processing apparatus 1.

The workpiece holder 13 is accommodated in the interior space L of the chamber 11, and holds the workpiece W. Examples of the workpiece holder 13 include a chuck table. The workpiece W loaded to an interior of the chamber 11 via the open/close door 25 is held by the workpiece holder 13 in a stable manner.

The connecting plate 15 constitutes one face of an outer wall (casing) of the chamber 11. In this embodiment, the connecting plate 15 is located on a top face of chamber 11. Similar to the casing of the chamber 11, the connecting plate 15 is made of a conductive material such as metal, for example. The plasma generating units 7 are each connected to the plasma processing unit 9 via the connecting plate 15. That is, as shown in Fig. 4, the connecting plate 15 has through holes 27 corresponding to a shape of a distal end of each of the plasma generating units 7, and the distal ends of the plasma generating units 7 can fit into the through holes 27 individually. The distal end of each of the plasma generating units 7 fits into the through hole 27, whereby a space on a front side of the connecting plate 15 and a space on a back side of the connecting plate 15 (interior space L of the chamber 11) are shut off as shown in Fig. 1, and the interior space L is in a sealed state.

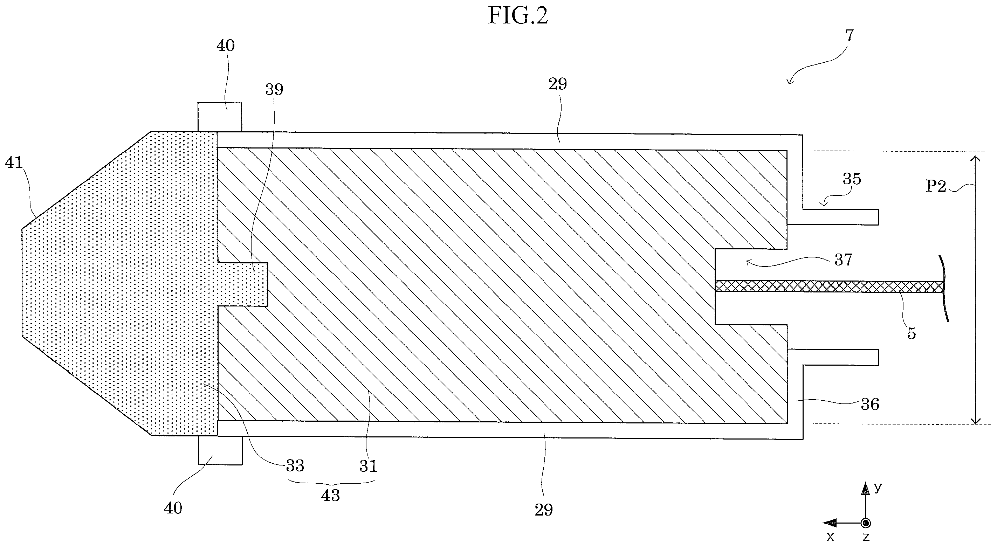

Now, description is made of a construction of the plasma generating unit 7. Fig. 2 is a longitudinal sectional view of the plasma generating unit 7. As shown in Fig. 2, the plasma generating unit 7 has an outer conductor 29, a first dielectric 31, a second dielectric 33, and a microwave supply port 35. The outer conductor 29 is a tubular member made of a conductive material such as metal, for example. The outer conductor 29 is a waveguide whose shape corresponds to that of a microwave propagation mode and has an opening 34 on its distal end side. The outer conductor 29 is closed by a partition 36 on its proximal end side (right side of Fig. 2). In the first embodiment, a cylindrical waveguide that propagates TM-mode microwaves is used as one example of the outer conductor 29.

The first dielectric 31 is a rod-shaped member that extends in a main axial direction of the outer conductor 29 (x-direction in Fig. 2, etc.), and is arranged inside of the outer conductor 29. The first dielectric 31 is made of a dielectric material that propagates microwaves, and examples of the dielectric material include aluminum oxide or quartz. The first dielectric 31 is connected to the microwave supply cable 5 on its proximal end side, and propagates microwaves, supplied from the microwave supply cable 5, from the proximal end side to the distal end side.

Moreover, the first dielectric 31 in the first embodiment has a magnitude of a diameter and a shape determined so as to fill the interior of the outer conductor 29. In this embodiment, it is assumed that the first dielectric 31 is a cylindrical member made of aluminum oxide and an outer diameter of the first dielectric is configured to be equal to an inner diameter of the outer conductor 29. The first dielectric 31 has a recess 37 formed on its proximal end side. In the first embodiment, the recess 37 extends in an x-direction, and is configured such that the microwave supply cable 5 is insertable thereinto in the x-direction.

The second dielectric 33 is arranged so as to close the opening 34 on the distal end side of the outer conductor 29, and is connected to the first dielectric 31. Similar to the first dielectric 31, the second dielectric 33 is made of a dielectric material that propagates microwaves, and examples of the dielectric material include aluminum oxide or quartz. In this embodiment, it is assumed that the second dielectric 33 is made of aluminum oxide.

As shown in Figs. 2 and 4, the first dielectric 31 is connected to the second dielectric 33 via a connecting portion 39. The connecting portion 39 is composed of a first connecting portion 39A formed at a distal end of the first dielectric 31 and a second connecting portion 39B formed at a proximal end of the second dielectric 33. The connecting portion 39 may connect the first dielectric 31 and the second dielectric 33 with use of a screwing construction, a fitting construction, or an engaging configuration appropriately.

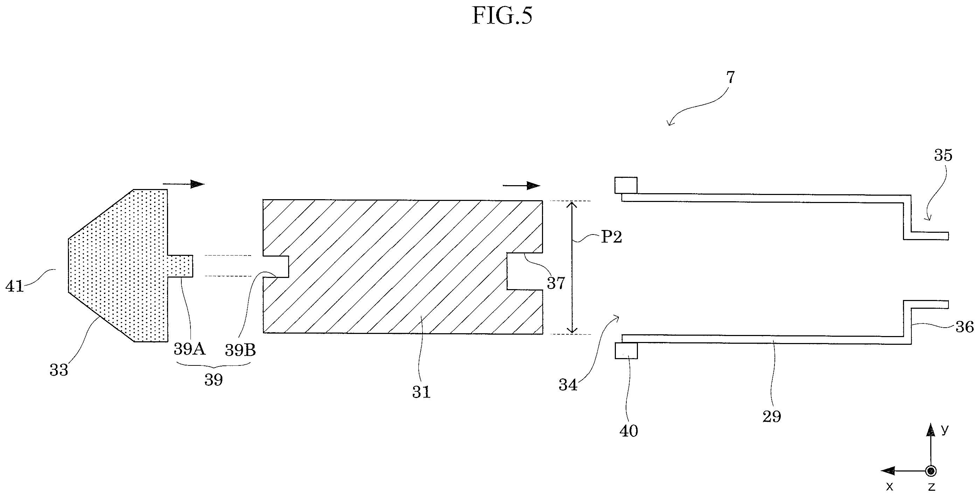

In the first embodiment, it is assumed that the connecting portion 39 connects the first dielectric 31 and the second dielectric 33 via screwing. As one example of a specific construction, the first connecting portion 39A is a recess with an internal thread formed therein and the second connecting portion 39B is a projection with an external thread formed therein. Moreover, as shown in Fig. 5, the first connecting portion 39A and the second connecting portion 39B are screwed each other, whereby the first dielectric 31 and the second dielectric 33 are stably connected.

It is assumed that a surface of the second dielectric 33 on the distal end side is an outer face 41. As shown in Figs. 1 and 4, the distal end of the plasma generating unit 7, i.e., the second dielectric 33, fits into the through hole 27, whereby the outer face 41 of the second dielectric 33 passes through the connecting plate 15 and extends into the interior space L of the chamber 11. That is, the first dielectric 31 is connected to the interior space L of the chamber 11 via the second dielectric 33.

By connecting the first dielectric 31 and the second dielectric 33, microwave energy propagated from the proximal end to the distal end of the first dielectric 31 is further propagated to the proximal end of the second dielectric 33. The microwave energy is then propagated to the outer face 41, as the distal end of the second dielectric 33, and can generate plasma around the outer face 41. It should be noted in this embodiment that the outer face 41 (surface adjacent to the distal end) of the second dielectric 33 is tapered from the proximal end side toward the distal end side of the outer conductor 29.

In the first embodiment, the first dielectric 31 is connected to the second dielectric 33 via the connecting portion 39 to form one dielectric member 43 in its entirety. The dielectric member 43 formed by the first dielectric 31 and the second dielectric 33 acts as one dielectric member that propagates microwaves from the proximal end side end to the distal end side. Then, with a construction of connecting the first dielectric 31 with the second dielectric 33, various types of second dielectric 33 whose outer faces 41 have different shapes are replaced and used appropriately for the first dielectric 31, whereby a shape of the distal end of the dielectric member 43 can be changed appropriately.

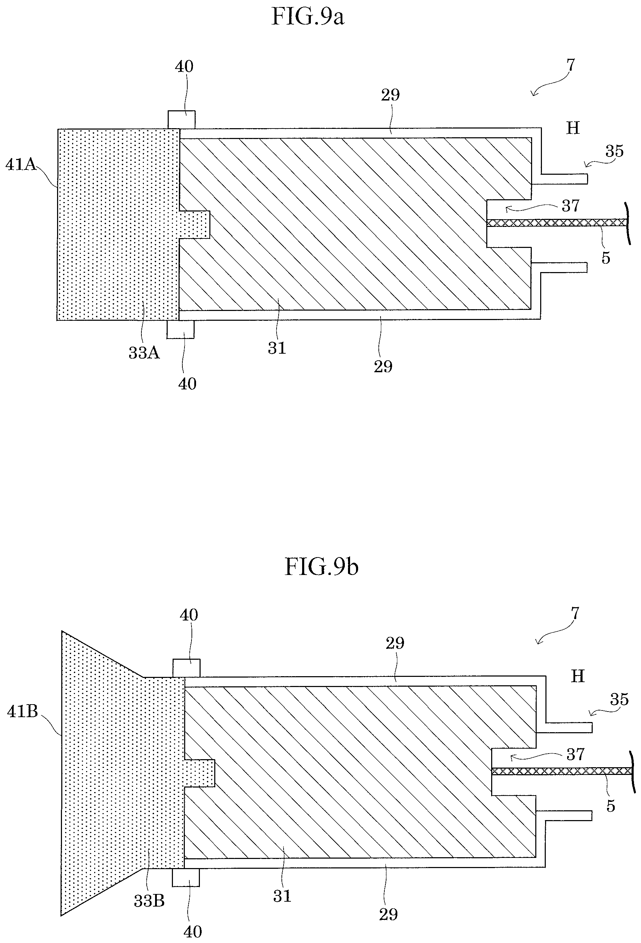

As an example, the second dielectric 33 having the outer face 41 with a shape tapered toward the distal end side is removable from the first dielectric 31, and a second dielectric 33A with a cylindrical shape is connected to the first dielectric 31, as shown in Fig. 9(a), to form a dielectric member 43. An outer diameter of the second dielectric 33A is constant from the proximal end side toward the distal end side, and an outer diameter of an outer face 41A is substantially equal to an outer diameter of the outer conductor 29. Since the second dielectric 33A is not necessarily processed into a tapered shape unlike the second dielectric 33, the manufacturing cost of the plasma generating unit 7 can be kept low when the plasma generating unit 7 is provided with the second dielectric 33A.

As another example, as shown in Fig. 9(b), a second dielectric 33B having a shape tapered from the distal end side toward the proximal end side can be connected to the first dielectric 31 to form the dielectric member 43. A diameter of an outer face 41B provided for the second dielectric 33B is made longer than the diameter of the outer conductor 29. In other words, the outer face 41B has a plane whose area is larger than those of the outer face 41 and outer face 41A. Therefore, plasma processing can be performed more widely in the workpiece W with use of the plasma generating unit 7 provided with the second dielectric 33B. This results in enhanced plasma processing efficiency in the plasma processing apparatus 1.

As shown in Figs. 9(a) and 9(b), in the plasma generating unit 7 according to the first embodiment, the second dielectrics 33, 33A, 33B, and the like having various shapes of the outer faces 41 can be replaced and used appropriately depending on an area where plasma is generated or application of the plasma processing. This can make the plasma generating unit 7 more versatile.

A ring-shaped stopper 40 is provided on an outer circumference face at the distal end of the outer conductor 29. As shown in Figs. 1 and 4, by fitting the plasma generating unit 7 into the through hole 27 provided in the connecting plate 15, the stopper 40 on the outer circumference face of the outer conductor 29 contacts against an outer face of the connecting plate 15. The stopper 40 contacts against the connecting plate 15, whereby the plasma generating unit 7 connected to the plasma processing unit 9 can be maintained in a stable posture.

The microwave supply port 35 is located at the proximal end of the outer conductor 29, and guides the microwave supply cable 5 to the first dielectric 31. In the first embodiment, microwaves in a TM mode are propagated, so that the microwave supply port 35 is configured to extend axially at the proximal end side (bottom face) of the outer conductor 29 as a waveguide. That is, the microwave supply port 35 is arranged so as to pass through the partition 36 of the outer conductor 29 in the x-direction. The microwave cable 5 is guided through the interior of the microwave supply port 35 to the recess 37 of the first dielectric 31, inserted in a direction where the recess 37 extends (x-direction in the first embodiment), and connected to the first dielectric 31.

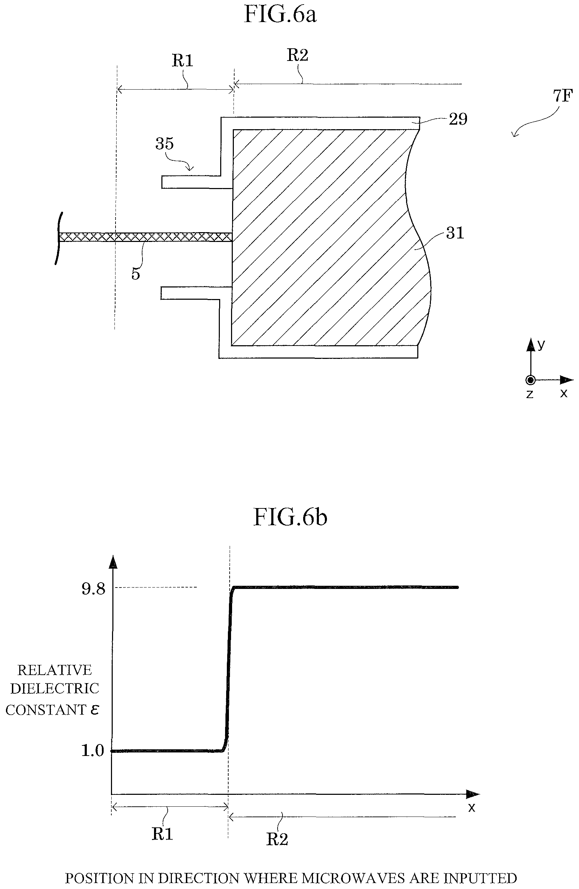

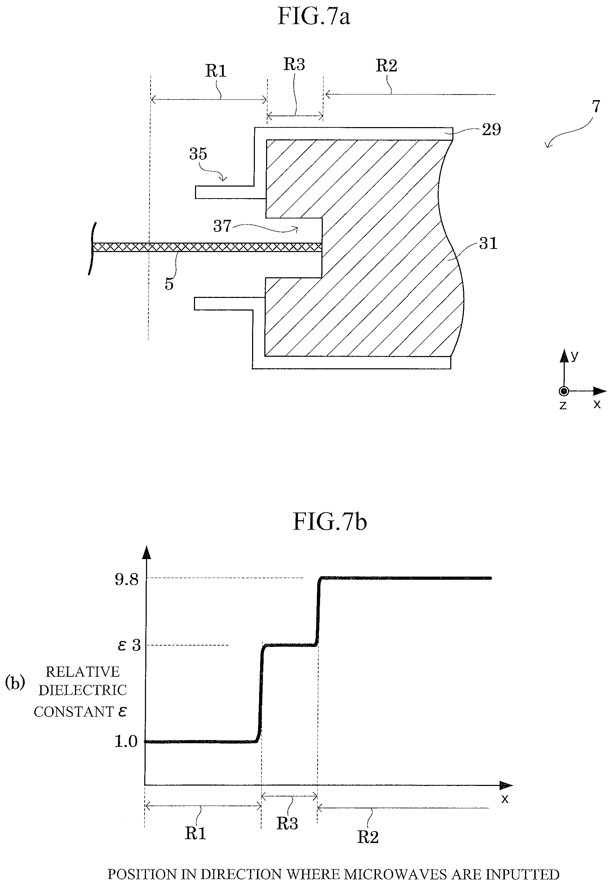

In the first embodiment, the recess 37 acts as a gap for matching impedance at the connecting portion of the microwave supply cable 5 and the first dielectric 31. In other words, the recess 37 matches the impedance more suitably by moderating change in relative dielectric constant in a direction where microwaves are inputted (supplied). Now, description is made with use of Figs. 6 and 7 about an effect of a construction that the recess 37 is formed in the first dielectric 31 and the microwave supply cable 5 is connected to the first dielectric 31 via the recess 37.

Each drawing of Fig. 6 shows a construction of a comparative example in which the first dielectric 31 has no recess 37, whereas each drawing of Fig. 7 shows a configuration of the first embodiment in which the first dielectric 31 has the recess 37. Here, the plasma generating unit according to the comparative example in Fig. 6 is marked with a numeral 7F to distinguish it from the plasma generating unit 7 in the first embodiment.

Fig. 6(a) is a longitudinal sectional view of a proximal end of a plasma generating unit 7F according to the comparative example, and Fig. 6(b) is a graph of a change in relative dielectric constant in an input direction of microwaves. As shown in Fig. 6(a), in the configuration of the comparative example having no recess 37, the microwave supply cable 5 contacts a bottom face of the first dielectric 31 as a cylindrical member, whereby the two are connected. In this case, a medium surrounding the microwave supply cable 5 is typically air. Since a relative dielectric constant of air (relative dielectric constant ε) is 1.0, a region R1 where the microwave supply cable 5 extends in the x-direction, in which microwaves are inputted, has ε = 1.0, as shown in Fig. 6(b). It should be noted that the relative dielectric constant in the region R1 changes in accordance with the relative dielectric constant of the medium if the medium surrounding the microwave supply cable 5 is a substance different from air.

On the other hand, a relative dielectric constant of aluminum oxide, which constitutes the first dielectric 31, is 9.8. Therefore, a region R2 where the first dielectric 31 is placed has ε = 9.8 in the x-direction. As a result, as shown in Fig. 6(b), the relative dielectric constant changes suddenly from 1.0 to 9.8 at a connecting portion between the microwave supply cable 5 and the first dielectric 31 (a boundary between the region R1 and the region R2). As described above, if the relative dielectric constant changes suddenly in the direction where the microwave is inputted, it is relatively difficult to match the impedance between input and output sides in the plasma generating unit 7F.

In contrast to this construction without the recess 37, the plasma generating unit 7 with the recess 37 is divided into three regions in the x-direction in which microwaves are inputted. Fig. 7(a) is a longitudinal sectional view of the proximal end of the plasma generating unit 7 according to the first embodiment, and Fig. 7(b) is a graph of a change in relative dielectric constant in an input direction of microwaves. The plasma generating unit 7 with the recess 37 is divided into a region R1 where the microwave supply cable 5 extends, a region R2 of the first dielectric 31 where the recess 37 does not extend, and a region R3 of the first dielectric 31 where the recess 37 extends. The region R3 where the recess 37 is located is a region between the region R1 and the region R2.

In the region R1 in Fig. 7, a medium surrounding the microwave supply cable 5 is air. Therefore, the region R1 has a relative dielectric constant of 1.0 in Fig. 7, which is similar to Fig. 6. Moreover, in the region R2, the first dielectric 31 fills the interior of the outer conductor 29. Accordingly, the region R2 has the relative dielectric constant corresponding to a relative dielectric constant of a material (in this case, aluminum oxide) constituting the first dielectric 31 in the plasma generating unit 7 of Fig. 7, which is similar to Fig. 6. That is, the region R2 has a relative dielectric constant of 9.8.

Here, the relative dielectric constant in the region R3 where the recess 37 is formed is higher than the relative dielectric constant in the region R1 and lower than the relative dielectric constant in the region R2. In other words, in the region R3, the medium (air) filling the recess 37 and the material (aluminum oxide) constituting the first dielectric 31 are mixed in a radial direction (y-direction) of the outer conductor 29. As a result, a relative dielectric constant ε3 in the region R3 is a value between the relative dielectric constant of air of 1.0 and the relative dielectric constant of aluminum oxide of 9.8. By adjusting a ratio between a portion where the recess 37 is located and a portion where the first dielectric 31 is located in the region R3, a specific value of the relative dielectric constant ε3 can be determined to any value.

As a result, as shown in Fig. 7(b), the relative dielectric constant changes from 1.0 to ε3 at a portion where the microwave supply cable 5 is inserted into the recess 37 (a boundary between the region R1 and the region R3). Then, the relative dielectric constant changes from ε3 to 9.8 at the connecting portion between the microwave supply cable 5, inserted into the recess 37, and the first dielectric 31 (a boundary between the region R3 and the region R2). A difference between 1.0 and ε3 and a difference between 9.8 and ε3 are both smaller than a difference between 9.8 and 1.0. In other words, in the construction with the recess 37, the region R3 where the recess 37 is provided acts as a buffer region for a change in relative dielectric constant, and the relative dielectric constant changes slowly in the direction where microwaves are inputted.

Such a construction with the recess 37 can moderate a change in relative dielectric constant in the direction where microwaves are inputted. That is, by providing the region R3 corresponding to the buffer region, a sudden change in relative dielectric constant can be prevented, making it much easier to match the impedance between the input and output sides of the plasma generating unit 7 according to the first embodiment. In the first embodiment, the recess 37 corresponds to the relative dielectric constant buffer in the present invention.

### <Description of Operation>

The following describes operation of the plasma processing apparatus 1. Firstly, a workpiece W is loaded into the chamber 11 through the open/close door 25 using a workpiece transport mechanism not shown, and is placed on the workpiece holder 13. The workpiece holder 13 holds the workpiece W stably by a method like suction holding. Then, the workpiece holder 13 is moved appropriately to bring the area of the workpiece W to be subjected to a plasma processing closer to the outer face 41 of the plasma generating unit 7.

After the workpiece W is placed by bringing it close to the outer face 41, the interior space L of the chamber 11 is adjusted. That is, the control mechanism closes the open/close door 25 to seal the chamber 11, and then opens the electromagnetic valve 16 to activate the exhaust device 19. The exhaust device 19 activates, whereby air stagnating in the interior space L of the chamber 11 is exhausted.

After the interior space L of the chamber 11 is exhausted, the control mechanism closes the electromagnetic valve 16 and opens the electromagnetic valve 20 to activate the gas supply device 23. The gas supply device 23 is activated, whereby gas G for excitation is supplied to the interior space L of the chamber 11.

When the gas G is supplied to the interior space L of the chamber 11, the microwave generating unit 5 is activated to oscillate microwaves. The oscillated microwaves are supplied to the plasma generating unit 7 via the microwave supply cable 5. The supplied microwaves are propagated to the first dielectric 31 in a coupling device 35. That is, microwaves are propagated from the microwave supply cable 5, inserted into the recess 37, to the proximal end of the first dielectric 31.

At this time, a change in relative dielectric constant in the direction where microwaves are inputted is moderated by inserting the microwave supply cable 5 into the recess 37 formed in the first dielectric 31. Accordingly, the impedance of the microwaves is adjusted more suitably, achieving more reliable prevention of occurrence of unneeded reflected power.

The microwaves suppled to the proximal end of the first dielectric 31 are propagated inside of the first dielectric 31. That is, the microwaves propagate in the x-direction where the first dielectric 31 extends, from the distal end of the first dielectric 31 to the proximal end of the second dielectric 33. The microwaves propagated to the proximal end of the second dielectric 33 are propagated to the outer face 41 of the second dielectric 33. When the second dielectric 33 receives supply of the microwaves, the gas G is excited around the outer face 41 in the interior space L of the chamber 11, and plasma is generated. The workpiece W placed adjacent to the outer face 41 undergoes predetermined processing with the plasma generated by the plasma generating unit 7. After the plasma processing to the workpiece W is completed, the control mechanism opens the open/close door 25 to unload the workpiece W out of the chamber 11, and a series of steps of the workpiece W concerning the plasma processing is completed.

### <Effect of construction in first embodiment>

In the plasma processing apparatus 1 according to the first embodiment, the plasma generating unit 7 has a waveguide structure in its entirety, and the first dielectric 31 made of a dielectric material is arranged inside the outer conductor 29 as a waveguide. Then, the microwaves are propagated from the proximal end to the distal end with use of the first dielectric 31 and the second dielectric 33 connected to the first dielectric 31. That is, since the plasma generating unit 7 according to the first embodiment does not have a conductor in an interior of the outer conductor 29, so an insulation distance can be elongated.

Now, description is made of an effect of the construction of the first embodiment, while comparing it with a conventional apparatus. A conventional plasma generating apparatus 100 adopts a coaxial tube structure. That is, in the plasma generating apparatus 100 as shown in Fig. 17, a central core 101, which is an electrical conductor, is located inside an outer shield 102, which corresponds to the outer conductor. Accordingly, since an insulation distance P1 of the conventional plasma generating apparatus 100 corresponds to a distance from the outer shield 102 to the central core 101, the insulation distance P1 is smaller than half the inner diameter of the outer shield 102. As a result, the insulation distance P1 is smaller than the diameter of the outer shield 102, leading to easy occurrence of dielectric breakdown in the plasma generating apparatus 100. In order to increase the insulation distance P1 for avoiding the dielectric breakdown, the diameter of the outer shield 102 is necessarily long, making it difficult to avoid increase in size of the plasma generating apparatus 100.

Another approach to avoid dielectric breakdown in the conventional apparatus is to reduce output of microwaves supplied. However, reducing the output of microwaves leads to lowered output of plasma in the plasma generating apparatus 100, resulting in decrease in efficiency of the plasma processing with use of the plasma generating apparatus 100.

On the other hand, the plasma processing apparatus 1 according to the first embodiment uses the first dielectric 31 and the second dielectric 33, made of dielectric materials, to propagate microwaves toward a distal end. That is, as shown in Fig. 2 and the like, there is no need to arrange a conductor inside the outer conductor 29. Thus, the insulation distance P2 of the plasma generating unit 7 corresponds to the inner diameter of the outer conductor 29. In other words, when compared to the conventional apparatus, the plasma generating unit 7 according to the first embodiment can ensure an insulation distance more than twice as long even if the inner diameter of the outer conductor 29 is the same. Therefore, the outer conductor 29 can be made compact while avoiding dielectric breakdown.

In addition, output of the plasma in the plasma generating unit 7 can be enhanced since dielectric breakdown can be avoided while microwaves having high output are supplied to the plasma generating unit 7. This results in enhanced plasma processing efficiency in the plasma processing apparatus 1 while dielectric breakdown is prevented.

In particular, when microwaves are propagated only at a TE11 mode as a main propagation mode or a TM01 mode as a first higher-order mode, the first dielectric 31 made of the dielectric material is necessarily located inside the outer conductor 29 to make the outer conductor 29 small in a radial direction. Accordingly, the structure according to the first embodiment enables propagation of microwaves only at the main propagation mode or the first higher-order mode while dielectric breakdown is prevented.

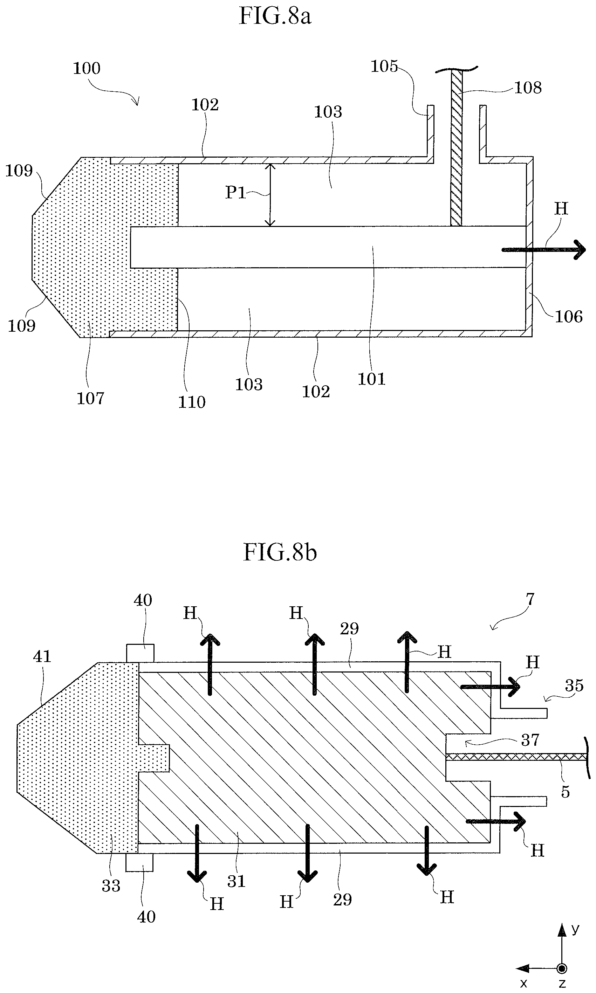

Moreover, in the plasma generating unit 7 according to the first embodiment, the first dielectric 31 that propagates microwaves from the proximal end side to the distal end side is configured to fill the interior of the outer conductor 29. Such a construction can prevent heat accumulation in the plasma generating unit 7. The following describes an effect of preventing the heat accumulation in the construction of the first embodiment while comparing it with the conventional example in Fig. 8.

As shown in Fig. 17, in the conventional plasma generating apparatus 100, a propagation medium 103, of which air is an example, is located between a side face of the central core 101 and the outer shield 102. Accordingly, the central core 101 is in contact, only at its proximal end, with the outer shield 102 corresponding to the outer conductor. Therefore, a contact area between the central core 101 and the outer shield 102 is very narrow in the conventional plasma generating apparatus 100.

In the conventional plasma generating apparatus 100 as above, it is difficult to release heat generated in the central core 101 to the outside. The propagation medium 103 in contact with a large part of the central core 101 is typically air, which has a low thermal conductivity. That is, as shown in Fig. 8(a), heat H generated in the central core 101 propagating microwaves is conducted to the outer shield 102 and is released to the outside of the plasma generating apparatus 100. However, in the conventional plasma generating apparatus 100, the contact area between the central core 101 and the outer shield 102 is narrow, leading to a very lowered discharge efficiency of the heat H. As a result, the heat generated in the central core 101 is easily accumulated inside the outer shield 102 to rise in temperature easily. Therefore, even when the microwaves supplied to the plasma generating apparatus 100 have low output, a problem caused by high-temperature heat may easily occur.

On the other hand, in the plasma generating unit 7 according to the first embodiment, the first dielectric 31 fills the interior of the outer conductor 29. That is, the first dielectric 31 propagating microwaves is in contact with the outer conductor 29 over its entire outer circumference. Accordingly, the contact area between the first dielectric 31 and the outer conductor 29 is very large. Thus, as shown in Fig. 8(b), the heat H generated in the first dielectric 31 is conducted to the outer conductor 29 widely, and is released outside the plasma generating unit 7. As a result, since a heat exhaust efficiency of the plasma generating unit 7 can be enhanced largely, heat can be prevented from being accumulated inside the outer conductor 29 more reliably. Therefore, high temperatures in the plasma generating unit 7 can be avoided while microwaves having high output are supplied to the plasma generating unit 7, achieving enhanced output of plasma in the plasma generating unit 7.

Furthermore, since the heat H of the first dielectric 31 is conducted over the entire outer conductor 29 in the plasma generating unit 7 according to the first embodiment, the first dielectric 31 can be cooled rapidly by arranging a cooling member outside the outer conductor 29. As an example, the first dielectric 31 can be cooled rapidly by water-cooling the outer conductor 29. Accordingly, a heat exhaust efficiency in the plasma generating unit 7 can be further enhanced, and the heat of the plasma generating unit 7 can be exhausted easily.

Moreover, since the shape of the outer face 41 can be changed appropriately in the plasma generating unit 7 according to the first embodiment, versatility of the plasma processing can be improved. In the conventional plasma generating apparatus 100 having the coaxial tube structure, the outer surface 109 of the dielectric body 107 is necessarily tapered from the proximal end side toward the distal end side in view of impedance matching. In other words, since the shape of the outer surface 109 is limited, the conventional plasma generating apparatus 100 has low versatility of the plasma processing. Moreover, the dielectric body 107 is tapered, leading to a narrow area of a leading edge of the outer surface 109. This results in a narrow area where plasma processing can be performed on a workpiece W at a time, which reduces the efficiency of the plasma processing.

On the other hand, since the plasma generating unit 7 according to the first embodiment has a waveguide structure in its entirety, impedance can be matched even if the distal end of the dielectric member 43 is not tapered. Therefore, the distal end of the dielectric member 43 (the distal end of the second dielectric 33) can be made in various shapes, for example, a cylindrical shape or a shape that becomes thicker toward the distal end side. In other words, the plasma generating unit 7 according to the first embodiment can change a shape of the distal end of the dielectric member 43 in accordance with the area subjected to the plasma processing and the application while the impedance matching is performed, whereby the versatility of the plasma generating unit 7 is improved.

In the conventional plasma generating apparatus 100, the dielectric body 107 is located only on the distal end of the outer shield 102. Accordingly, not only the outer surface 109 on the distal end side of the dielectric body 107 but also the outer surface 110 on the proximal end side is necessarily tapered for more suitable impedance matching. On the other hand, in the plasma generating unit 7 according to the first embodiment, the first dielectric 31 fills the interior of the outer conductor 29. Thus, the impedance can be matched suitably without tapering the first dielectric 31 inside the outer conductor 29. That is, since both sides of the dielectric material 43 is not necessarily tapered in the plasma generating unit 7, the manufacturing cost of the plasma generating unit 7 can be reduced while the impedance matching efficiency is ensured.

### Second embodiment

The following describes a second embodiment of the present invention. Here, same reference numerals are to be merely applied to identify same elements as in the plasma processing apparatus 1 described in the first embodiment, and different elements are to be described in detail. A plasma generating unit 7A in the second embodiment differs from the plasma generating unit 7 in the first embodiment in a construction of a part to which the microwave supply cable 5 is connected.

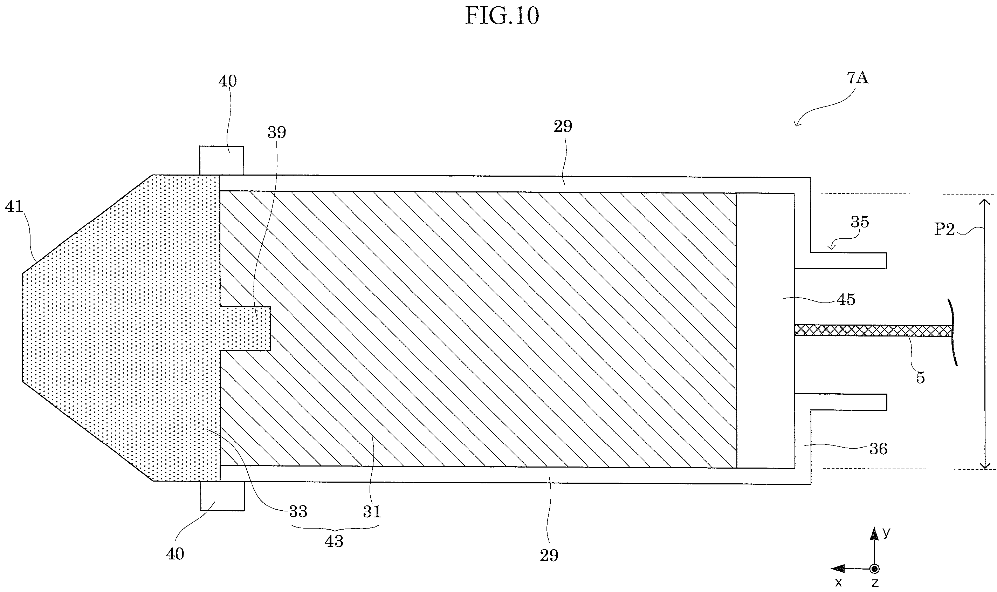

In the plasma generating unit 7A according to the second embodiment, the first dielectric 31 includes a connecting member 45 instead of the recess 37, as shown in Fig. 10. The connecting member 45 is located in a part where the first dielectric 31 and the microwave supply cable 5 are connected. In the second embodiment, it is assumed that the connecting member 45 is located on the proximal end side of the first dielectric 31. Although the second embodiment shows a construction in which a diameter of the connecting member 45 is equal to a diameter of the first dielectric 31, the diameter of the connecting member 45 may be smaller than the diameter of the first dielectric 31. As an example, the connecting member 45 may have a diameter substantially equal to the diameter of the recess 37 shown in Fig. 2.

The connecting member 45 is composed of a dielectric material having a relative dielectric constant lower than that of the first dielectric 31. As an example, if the first dielectric 31 is composed of aluminum oxide (ε = 9.8), quartz (ε = 3.78) may be a material used for the connecting member 45. Moreover, the connecting member 45 is composed of a dielectric material having a relative dielectric constant higher than that of a medium surrounding the microwave supply cable 5. Since the medium of the microwave supply cable 5 is air (ε = 1.0) in the second embodiment, which is similar to the first embodiment, quartz is an example of a preferred dielectric material for the first dielectric 31 in the second embodiment.

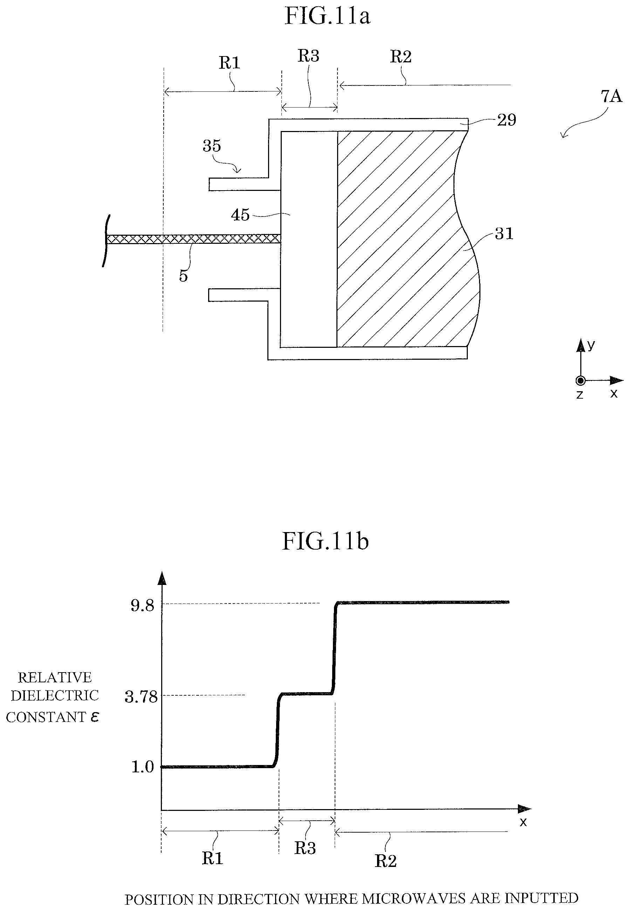

At a connecting portion between the microwave supply cable 5 and the first dielectric 31 in the second embodiment, the connecting member 45 is a region where a change in relative dielectric constant is moderated. In other words, the connecting member 45 matches the impedance more suitably by moderating the change in relative dielectric constant in a direction where microwaves are inputted. Now, description is made with use of Figs. 6 and 11 about an effect of a construction where the microwave supply cable 5 is connected to the first dielectric 31 via the connecting member 45.

As shown in Fig. 6(a), the relative dielectric constant changes suddenly in the construction where the microwave supply cable 5 is connected to the first dielectric 31 without the connecting member 45. That is, a medium surrounding the microwave supply cable 5 is air. Accordingly, as shown in Fig. 6(b), the region R1 where the microwave supply cable 5 extends in the x-direction, in which microwaves are inputted, has a relative dielectric constant ε of 1.0. On the other hand, since the first dielectric 31 is composed of aluminum oxide, the region R2 where the first dielectric 31 is arranged has a relative dielectric constant ε of 9.8. As a result, the relative dielectric constant changes suddenly from 1.0 to 9.8 at a connecting portion between the microwave supply cable 5 and the first dielectric 31 (a boundary between the regionR1 and the region R2).

On the other hand, the plasma generating unit 7A with the connecting member 45 is divided into three regions in the x-direction in which microwaves are inputted. Fig. 11(a) is a longitudinal sectional view of a proximal end of the plasma generating unit 7A according to the second embodiment, and Fig. 11(b) is a graph of a change in relative dielectric constant in an input direction of microwaves. The plasma generating unit 7 with the recess 37 is divided into a region R1 where the microwave supply cable 5 extends, a region R2 where the first dielectric 31 is arranged, and a region R3 where the connecting member 45 is arranged.

In Fig. 11, the medium surrounding the microwave supply cable 5 in the region R1 is air, so that the region R1 has a relative dielectric constant of 1.0 as shown in Fig. 11(b). Moreover, in the region R2, the first dielectric 31 fills the interior of the outer conductor 29. Accordingly, the region R2 has the relative dielectric constant of 9.8, which corresponds to a relative dielectric constant of a material (in this case, aluminum oxide) constituting the first dielectric 31. The region R3 has the relative dielectric constant of 3.78, which corresponds to a relative dielectric constant of a material (in this case, quartz) constituting the connecting member 45.

As a result, as shown in Fig. 11(b), the relative dielectric constant changes from 1.0 to 3.78 at a portion where the microwave supply cable 5 is connected to the connecting member 45 (a boundary between the region R1 and the region R3). Then, the relative dielectric constant of the connecting portion of the connecting member 45 and the first dielectric 31 (a boundary between the region R3 and the region R2) changes from 3.78 to 9.8. In other words, in a construction provided with the connecting member 45 made of a material whose relative dielectric constant is lower than that of the first dielectric 31 and higher than that of the medium surrounding the microwave supply cable 5, the region R3 where the connecting member 45 is provided acts as a buffer region for a change in relative dielectric constant, and the relative dielectric constant changes slowly in the direction where microwaves are inputted.

In such a construction of the second embodiment with the connecting member 45, a change in relative dielectric constant can be moderated in the direction where microwaves are inputted, which is similar to the construction of the first embodiment with the recess 37. That is, by providing the region R3 corresponding to a buffer region, a sudden change in relative dielectric constant can be prevented, making it much easier to match the impedance between the input and output sides of the plasma generating unit 7A according to the second embodiment. In the second embodiment, the connecting member 45 corresponds to the relative dielectric constant buffer in the present invention. The operation of the plasma processing apparatus 1 with the plasma generating unit 7A according to the second embodiment is common to that in the first embodiment, of which description of the operation is omitted.

### Third embodiment

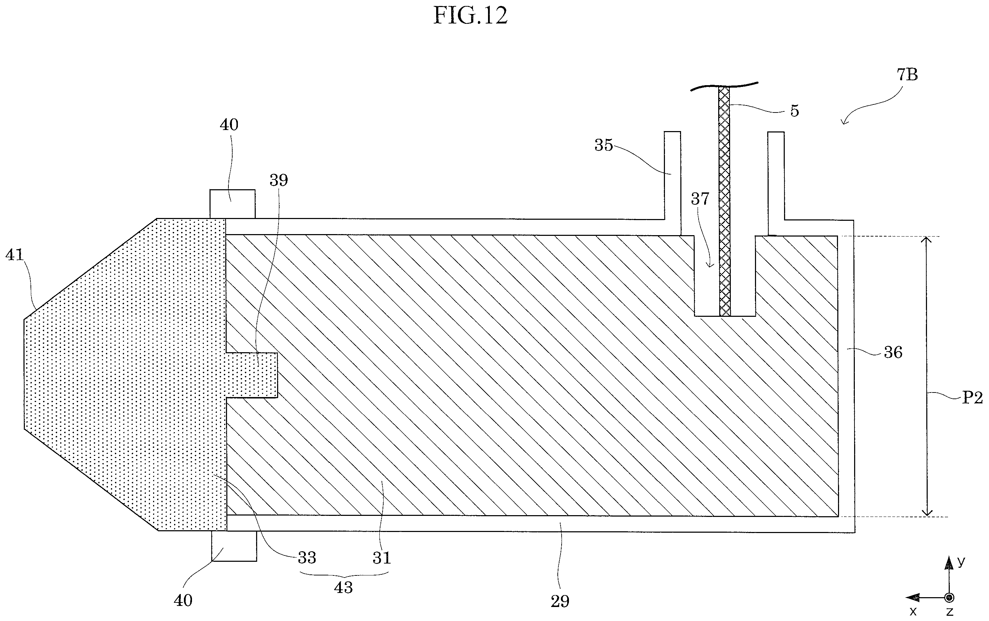

The following describes a third embodiment of the present invention. Here, same reference numerals are to be merely applied to identify same elements as in the plasma processing apparatus 1 described in the first embodiment, and different elements are to be described in detail. A plasma generating unit 7B in the third embodiment differs from the plasma generating unit 7 in the first embodiment in its arrangement. Fig. 12 is a longitudinal sectional view of the plasma generating unit 7B according to the third embodiment.

In the first embodiment, a cylindrical waveguide that propagates TM-mode (especially, TM01-mode) microwaves is used as the outer conductor 29. On the other hand, in the plasma generating unit 7B according to the third embodiment, a cylindrical waveguide that propagates TE-mode (especially, TE11-mode) microwaves is used as an outer conductor 29B. Accordingly, as shown in Fig. 12, the microwave supply port 35 that guides the microwave supply cable 5 is located on a side face of the outer conductor 29B. In the third embodiment, the microwave supply port 35 is located on a part of the side face of the outer conductor 29B near the proximal end side.

Then, in the third embodiment, a recess 37B id formed in the side face of the first dielectric 31. The recess 37B is positioned in connection with the microwave supply port 35, and extends in the radial direction (y-direction in Fig. 12) of the first dielectric 31. The microwave supply cable 5 is guided by the microwave supply port 35, and is inserted into the recess 37B. Since the recess 37B extends in the y-direction, the microwave supply cable 5 is inserted in the y-direction and is connected to the first dielectric 31. In other words, the direction where microwaves are inputted is the y-direction in the third embodiment.

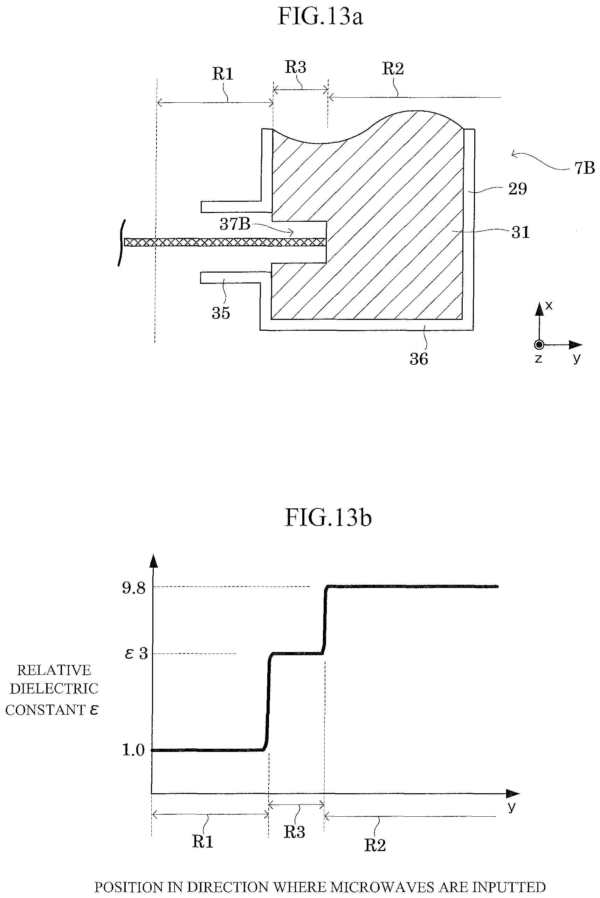

A change in relative dielectric constant in the direction where microwaves are inputted in the third embodiment is as shown in Fig. 13. Fig. 11(a) is a longitudinal sectional view of a proximal end of the plasma generating unit 7B according to the third embodiment, and Fig. 11(b) is a graph of a change in relative dielectric constant in an input direction of microwaves. The plasma generating unit 7B with the recess 37B is divided into three regions in the y-direction in which microwaves are inputted. That is, the divided regions are a region R1 where the microwave supply cable 5 extends, a region R2 that is filled with the first dielectric 31, and a region R3 where the recess 37B is located.

A medium surrounding the microwave supply cable 5 is air in the third embodiment, which is similar to the first embodiment and the like. Therefore, the region R1 has a relative dielectric constant of 1.0 as shown in Fig. 13(b). Moreover, in the region R2, the first dielectric 31 fills the interior of the outer conductor 29. Therefore, the region R2 has a relative dielectric constant of 9.8.

In the region R3, the medium (air) filling the recess 37 and the material (aluminum oxide) constituting the first dielectric 31 are mixed in a main axial direction (x-direction) of the outer conductor 29. As a result, a relative dielectric constant ε3 in the region R3 is a value between the relative dielectric constant of air of 1.0 and the relative dielectric constant of aluminum oxide of 9.8. That is, the relative dielectric constant in the region R3 where the recess 37 is formed becomes higher than the relative dielectric constant in the region R1 and lower than the relative dielectric constant in the region R2.

As a result, as shown in Fig. 13(b), the relative dielectric constant changes from 1.0 to ε3 at a portion where the microwave supply cable 5 is inserted into the recess 37B (a boundary between the region R1 and the region R3). Then, the relative dielectric constant changes from ε3 to 9.8 at the connecting portion between the microwave supply cable 5, inserted into the recess 37B, and the first dielectric 31 (a boundary between the region R3 and the region R2). Accordingly, in the construction with the recess 37B, the region R3 where the recess 37 is provided acts as a buffer region for a change in relative dielectric constant, and the relative dielectric constant changes slowly in the direction (y-direction) where microwaves are inputted. This results in much easier impedance matching between the input and output sides.

In the plasma processing apparatus 1 with the plasma generating unit 7B according to the third embodiment, microwaves oscillated by the microwave generating unit 3 are inputted to the plasma generating unit 7B in the y-direction. At this time, providing the recess 37B leads to a moderated change in relative dielectric constant when microwaves are inputted to the dielectric member 43 (first dielectric 31). The microwaves inputted to the dielectric member 43 are propagated from the proximal end side to the distal end side along the x-direction where the dielectric member 43 (first dielectric 31 and second dielectric) extends. Then, gas G inside the chamber 11 is excited at the outer face 41 located at the distal end of the dielectric member 43 (distal end of the second dielectric 33), and plasma is generated. With such a plasma generating unit according to the present invention, plasma can be generated with use of microwaves at a greater variety of propagation modes than those used by the conventional apparatus.

### <Other embodiments>

The embodiments disclosed here are all illustrative in every aspect, but not restrictive. The scope of the invention includes claims and all modifications within the meaning and range equivalent to the claims. As one example, the invention may be modified as follows.

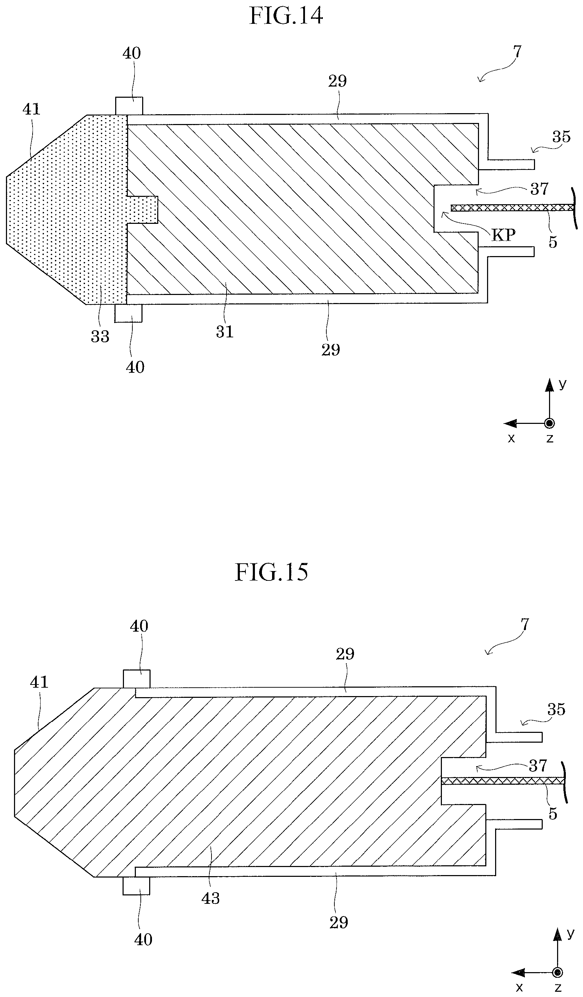

(1) In each of the embodiments described above, the construction in which the outer conductor 29 is a cylindrical waveguide is illustrated, but the outer conductor 29 is not limited to have the cylindrical shape. As one example, when the plasma generating unit 7 propagates TE10 mode microwaves, a rectangular waveguide may be used as the outer conductor 29. Unlike the conventional plasma generating apparatus 100 that uses a coaxial tube as the outer conductor, the outer conductor 29 with a waveguide structure is not limited to have the cylindrical shape in cross-section. Therefore, the plasma processing apparatus 1 according to each of the embodiments can perform a plasma processing in response to microwaves with various types of propagation modes.
(2) In each of the embodiments described above, the microwave supply cable 5 is not limited to have a construction where it contacts against the first dielectric 31 or the connecting member 45. That is, as shown in Fig. 14, the microwave supply cable 5 may be arranged with a gap KP having a predetermined distance to the first dielectric 31 and the like. The distance of the gap KP is determined as a value sufficient to propagate microwaves from the microwave supply cable 5 to the first dielectric 31 or the connecting member 45. The predetermined gap KP is formed between the microwave supply cable 5 and the first dielectric 31, achieving more suitable impedance matching. In the present invention, it is assumed that the feature "the microwave supply cable 5 is connected to the first dielectric 31" includes not only a construction in which the microwave supply cable 5 contacts against the first dielectric 31 as shown in Fig. 2 and the like, but also a construction in which the microwave supply cable 5 is close enough to the first dielectric 31 to propagate the microwave as shown in Fig. 14.
(3) In each of the embodiments described above, the construction in which the two members, the first dielectric 31 and the second dielectric 33, are combined as the dielectric member 43 is exemplified. However, this is not limitative, and the first dielectric 31 and the second dielectric 33 may be integrated. That is, as shown in Fig. 15, the dielectric member 43 may be a single member, and may include the outer face 41 at its distal end.
(4) In each of the embodiments describes above, the first dielectric 31 is not limited to have a construction where it fills the interior of the outer conductor 29 as long as the outer conductor 29 has a waveguide structure and has no conductor inside thereof. That is, as shown in Fig. 16, the construction of the invention also includes a construction in which the outer diameter of the first dielectric 31 is smaller than the inner diameter of the outer conductor 29 and an internal medium 47 is arranged between the first dielectric 31 and the outer conductor 29. Examples of the internal medium 47 include air.
(5) In each of the embodiments describes above, the configuration for the present invention also includes a configuration with the plasma generating unit 7F as shown in Fig. 6 as long as the outer conductor 29 has a waveguide structure and has no conductor inside thereof. That is, the construction in which the recess 37 or the connecting member 45 is provided in the first dielectric 31 is not limitative as long as the outer conductor 29 has a waveguide structure and has no conductor inside thereof.
(6) In each of the embodiments described above, the first dielectric 31 and the second dielectric 33 are not limited to be composed of the same material, but may be composed of different materials. That is, the first dielectric 31 may be composed of a first material L1 having dielectricity and a relative dielectric constant ε4, and the second dielectric 33 may be composed of a second material L2 having dielectricity and a relative dielectric constant ε5.

Moreover, when the first dielectric 31 and the second dielectric 33 are made of different materials, the connecting portion 39 serves as a region to moderate a change in relative dielectric constant. That is, the connecting portion 39 serves as a region that moderates a change in relative dielectric constant when microwaves are inputted from the first dielectric 31 to the second dielectric 33. Especially when the connecting portion 39 is configured to connect the recess and the projection, the connecting portion 39 serves as the region to moderate a change in relative dielectric constant more suitably.

The construction of a plasma generating unit 7C according to the modification is assumed to be same as that of the plasma generating unit 7 according to the first embodiment except that the first dielectric 31 and the second dielectric 33 are made of different materials. That is, in the plasma generating unit 7C according to the modification, the connecting portion 39 is composed of a first connecting portion 39A as a recess in which an internal thread is formed, and a second connecting portion 39B as a projection in which an external thread is formed. Here, description is made taking the case as one example where the relative dielectric constant ε5 of the second material L2 is higher than the relative dielectric constant ε4 of the first material L1.

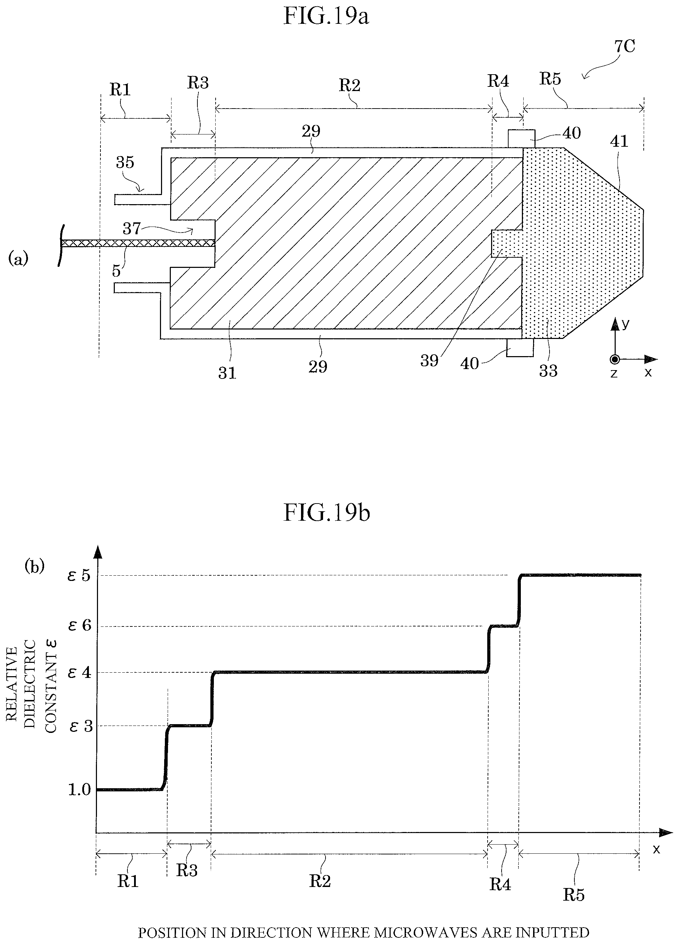

A change in relative dielectric constant in the direction where microwaves are inputted in this modification is as shown in Fig. 19. Fig. 19(a) is a longitudinal sectional view of the plasma generating unit 7C according to the modification, and Fig. 19(b) is a graph of a change in relative dielectric constant in an input direction of microwaves. The plasma generating unit 7C with the recess 37 and the connecting portion 39 is divided into five regions in the x-direction in which microwaves are inputted. That is, the divided regions are a region R1 where the microwave supply cable 5 extends, a region R2 that is filled with the first dielectric 31, a region R3 where the recess 37 is located, a region R4 where the connecting portion 39 is located, and a region R5 where the second dielectric 33 is located.

In the region R1 in Fig. 19(a), a medium surrounding the microwave supply cable 5 is air. Therefore, the region R1 has a relative dielectric constant of 1.0 in Fig. 19(b), which is similar to Fig. 6 and the like. Moreover, in the region R2, the first dielectric 31 fills the interior of the outer conductor 29. Accordingly, the region R2 has a relative dielectric constant corresponding to the relative dielectric constant ε4 of the first material L1 constituting the first dielectric 31. Moreover, the second dielectric 33 are filled in the region R5 in the y-direction. Accordingly, the region R5 has a relative dielectric constant corresponding to the relative dielectric constant ε5 of the second material L2 constituting the second dielectric 33.

Here, the relative dielectric constant in the region R3 where the recess 37 is formed is higher than the relative dielectric constant in the region R1 and lower than the relative dielectric constant in the region R2. In other words, in the region R3, the medium (air) filling the recess 37 and the first material L1 constituting the first dielectric 31 are mixed in a radial direction (y-direction) of the outer conductor 29. As a result, a relative dielectric constant ε3 in the region R3 is a value between the relative dielectric constant of air of 1.0 and the relative dielectric constant ε4 of the first material L1.

Then, the relative dielectric constant in the region R4 where the connecting portion 39 is formed is higher than the relative dielectric constant in the region R2 and lower than the relative dielectric constant in the region R5. In other words, in the region R4, the second material L2 constituting the connecting portion 39 (first connecting portion 39B) and the first material L1 constituting the first dielectric 31 are mixed in the radial direction (y-direction) of the outer conductor 29. As a result, a relative dielectric constant ε6 in the region R4 is a value between the relative dielectric constant ε4 of the first material L1 and the relative dielectric constant ε5 of the second material L2. By adjusting a ratio between a portion where the connecting portion 39 is located and a portion where the first dielectric 31 is located in the region R4, a specific value of the relative dielectric constant ε6 can be determined to any value.

As a result, as shown in Fig. 19(b), the relative dielectric constant changes from 1.0 to ε3 at a portion where the microwave supply cable 5 is inserted into the recess 37 (a boundary between the region R1 and the region R3). Then, the relative dielectric constant changes from ε3 to ε4 at the connecting portion between the microwave supply cable 5, inserted into the recess 37, and the first dielectric 31 (a boundary between the region R3 and the region R2). A difference between 1.0 and ε3 and a difference between ε4 and ε3 are both smaller than a difference between ε4 and 1.0. In other words, in the construction with the recess 37, the region R3 where the recess 37 is provided acts as a buffer region for a change in relative dielectric constant, and the relative dielectric constant changes slowly in the direction where microwaves are inputted.

Moreover, in this modification, the connecting portion 39 acts as a second region that moderates a change in relative dielectric constant. That is, the relative dielectric constant changes from ε4 to ε6 at the boundary between the regionR2 and the region R4. Then, at the boundary between the region R4 and the region R5, the relative dielectric constant changes from ε6 to ε5. The difference between ε4 and ε6 and the difference between ε6 and ε5 are both smaller than the difference between ε4 and ε5. In other words, in the construction with the connecting portion 39, the region R4 where the connecting portion 39 is provided acts as a buffer region for a change in relative dielectric constant, and the relative dielectric constant changes more slowly in the direction where microwaves are inputted.

As above, in the plasma generating unit 7C according to this modification, a change in relative dielectric constant can be moderated by the recess 37 and also by the connecting portion 39. That is, by providing the region R4 corresponding to a second buffer region, a sudden change in relative dielectric constant can be prevented, making it much easier to match the impedance between the input and output sides of the plasma generating unit 7 according to the first embodiment. In this modification, the connecting portion 39 corresponds to the second relative dielectric constant buffer in the present invention.

The plasma generating unit 7C according to this modification is not limited to the configuration with the recess 37, and the recess 37 may be omitted. Moreover, in the plasma generating unit 7C according to this modification, the relative dielectric constant ε5 of the second material L2 may be lower than the relative dielectric constant ε4 of the first material L1. Regardless of a magnitude relationship between the relative dielectric constant ε4 and the relative dielectric constant ε5, provision of the connecting portion 39 corresponding to the second relative dielectric constant buffer avoids a sudden change in relative dielectric constant at the boundary between the first dielectric 31 and the second dielectric 33.

### Reference Signs List

- 1: plasma processing apparatus
- 3: microwave generating unit
- 5: microwave supply cable
- 7: plasma generating unit (plasma generating apparatus)
- 9: plasma processing unit
- 11: chamber
- 13: workpiece holder
- 15: connecting plate
- 29: outer conductor
- 31: first dielectric
- 33: second dielectric
- 34: opening
- 35: microwave supply port
- 36: partition
- 37: recess
- 39: connecting portion
- 41: outer face
- 43: dielectric member
- 45: connecting member

## Claims

1. A plasma generating apparatus, comprising:
a conductive waveguide having an opening at a first end;
a first dielectric member extending along a main axis of the waveguide in an interior of the waveguide, connected to a microwave supply cable that supplies microwaves, and configured to propagate the supplied microwaves to the first end side; and
a second dielectric member arranged so as to close the opening and configured to generate plasma with use of the microwaves propagated by the first dielectric member.

2. The plasma generating apparatus according to claim 1, wherein
the first dielectric member extends along the main axis of the waveguide so as to fill the interior of the waveguide.

3. The plasma generating apparatus according to claim 1, wherein
the first dielectric member includes a relative dielectric constant buffer configured to moderate a change in relative dielectric constant at a connecting portion with the microwave supply cable.

4. The plasma generating apparatus according to claim 3, wherein
the relative dielectric constant buffer is a recess formed in the first dielectric member, and
the microwave supply cable is inserted in a direction in which the recess extends.

5. The plasma generating apparatus according to claim 3, wherein
the relative dielectric constant buffer is a connecting member formed with a material whose relative dielectric constant is lower than that of the first dielectric member, and
the first dielectric member is connected to the microwave supply cable via the connecting member.

6. The plasma generating apparatus according to any of claims 1 to 5, wherein
the first dielectric member includes a second relative dielectric constant buffer configured to moderate a change in relative dielectric constant at a connecting portion with the second dielectric member.

7. A plasma processing apparatus, comprising:
a microwave supply unit configured to supply microwaves;
a plasma generating unit configured to generate plasma with use of the microwaves supplied from the microwave supply unit, and
a plasma processing unit configured to process a workpiece with use of the plasma generated by the plasma generating unit,
the plasma generating unit being the plasma generating apparatus according to any of claims 1 to 5.
